(19) Europäisches Patentamt
European Patent Office
Office européen des brevets

(11) **EP 4 765 636 A1**

(12) **DEMANDE DE BREVET EUROPEEN**

(43) Date de publication:
**24.06.2026 Bulletin 2026/26**

(21) Numéro de dépôt: **25224119.5**

(22) Date de dépôt: **16.12.2025**

(51) Classification Internationale des Brevets (IPC):
***H03H 11/04*** *(2006.01)*

(52) Classification Coopérative des Brevets (CPC):
**H03H 11/04**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **18.12.2024 FR 2414466**

(71) Demandeur: **THALES**
**92190 Meudon (FR)**

(72) Inventeurs:
• **AUGEREAU, Hugues**
**49309 Cholet (FR)**
• **GUERN, Pierre**
**49309 Cholet (FR)**

(74) Mandataire: **Lavoix**
**2, place d'Estienne d'Orves**
**75441 Paris Cedex 09 (FR)**

(54) **FILTRE ANALOGIQUE À GABARIT VARIABLE**

(57) La présente invention concerne un filtre analogique (10) à gabarit variable comportant, entre une entrée (18) pour un signal fréquentiel (22) à filtrer et une sortie (20) pour un signal filtré (24). Le filtre comporte un ensemble d'impédances de filtrage (26) avec au moins un condensateur à capacité variable (28, 32) disposé entre un point haut et un point bas, et comportant une entrée de commande (21) pour une tension de commande ($V_{ds}$) de la capacité du condensateur.

Le condensateur à capacité variable (28) est un transistor principal (28) dont la source et le drain forment respectivement les points haut et bas, l'entrée de commande (21) étant reliée au drain, la source et la grille étant connectées à des potentiels électriques pour un fonctionnement du transistor principal (28) dans un état bloqué.

FIG.1

EP 4 765 636 A1

**Description**

La présente invention concerne un filtre analogique à gabarit variable.

Compte tenu des technologies existantes aujourd'hui, l'homme du métier est capable de fabriquer des filtres très sélectifs dans le domaine de très hautes fréquences (de l'anglais *very high frequencies*).

Il est connu d'utiliser en fonction de la puissance d'entrée admissible, des filtres du type : diodes à capacité variable ou des filtres du type : diodes à capacité commutée. Le principe du premier type du filtre est que les diodes à capacité variable ont la particularité de se comporter comme un condensateur dont la valeur de la capacité électrique varie avec la tension appliquée à ses bornes. Ainsi, selon la valeur de la tension de commande appliquée, la capacité électrique et le diagramme de Bode du filtre intégrant la diode sont modifiés. Le gabarit du filtre sélectif peut donc être modifié en permanence. Ce type de filtre est peu énergivore, mais sa tenue en puissance est faible, i.e. environ 1mW.

Pour le second type de filtre, le principe est que les capacités sont commutées via des diodes **PIN** (de l'anglais Positive Intrinsic Negative), à l'état bloqué ou à l'état passant en fonction de la fréquence d'accord désirée.

Toutefois, l'utilisation d'un tel filtre augmente considérablement la consommation d'énergie bien que sa tenue en puissance soit forte i.e. environ 1W..

Le but de l'invention est alors de proposer un filtre sélectif alliant les deux caractéristiques la tenue en puissance d'entrée jusqu'à 0.5W et une consommation d'énergie faible ou quasi nul.

A cet effet, l'invention a pour objet un filtre analogique à gabarit variable comportant, entre une entrée pour un signal fréquentiel à filtrer et une sortie pour un signal filtré, un ensemble d'impédances de filtrage avec au moins un condensateur à capacité variable disposé entre un point haut et un point bas, et comportant une entrée de commande pour une tension de commande de la capacité du condensateur,

caractérisé en ce que le condensateur à capacité variable est un transistor principal dont la source et le drain forment respectivement les points haut et bas, l'entrée de commande étant reliée au drain, la source et la grille étant connectées à des potentiels électriques pour un fonctionnement du transistor principal dans un état bloqué.

L'utilisation des transistors en état bloqué permet d'avoir un filtre moins énergivore et une bonne tenue en puissance.

Suivant d'autres aspects avantageux de l'invention, le filtre à gabarit variable comprend une ou plusieurs des caractéristiques suivantes, prises isolément ou suivant toutes les combinaisons techniquement possibles :

- la source et la grille du transistor principal sont connectées à la masse ;
- le signal fréquentiel à filtrer est compris entre 30 MHz et 300 MHz ;
- le transistor principal est de type à effet de champ à grille métal-oxyde ;
- l'ensemble d'impédances de filtrage comporte un transistor optionnel dont le drain est relié à l'entrée de commande et dont la source et la grille sont connectées à des potentiels électriques pour un fonctionnement du transistor optionnel dans un état bloqué ;
- le filtre comporte un circuit d'adaptation d'impédance, le circuit d'adaptation d'impédance comprenant un condensateur d'entrée et une bobine d'entrée, la bobine d'entrée étant connectée entre l'entrée et la masse, le condensateur d'entrée étant connecté entre l'entrée et l'ensemble d'impédances de filtrage ;
- le filtre comporte une unité de filtrage disposée entre le drain du transistor principal et l'entrée de commande, l'unité de filtrage comprenant un condensateur de filtrage et une bobine de filtrage, le condensateur de filtrage étant connecté entre l'entrée de commande et la masse, la bobine de filtrage étant connectée entre l'entrée de commande et le drain du transistor principal ;
- l'ensemble d'impédances de filtrage comporte une structure symétrique avec deux transistors principaux, chacun reliés à l'entrée de commande ; et
- la tension de commande appliquée à chaque transistor principal est identique.

L'invention apparaîtra plus clairement à la lecture de la description qui va suivre, donnée uniquement à titre d'exemple non limitatif, et faite en référence aux dessins dans lesquels :

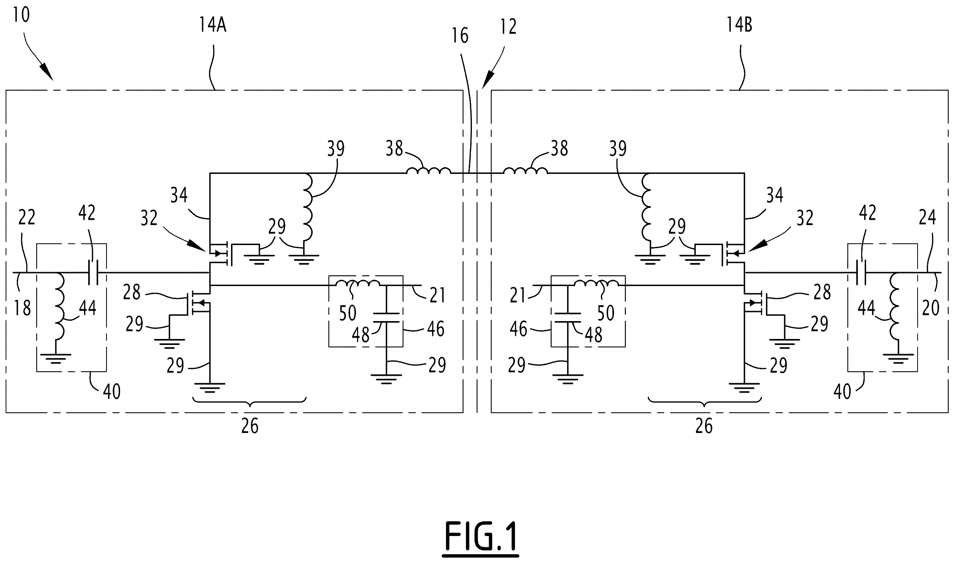

la figure 1 est un schéma d'un filtre passe bande à très haute fréquence selon l'invention.

Un filtre analogique 10 à gabarit variable est illustré sur la figure 1. Le filtre 10 est symétrique par rapport à un axe 12 et comporte deux modules de filtrage 14A, 14B connectés entre eux par une branche de connexion 16. Le filtre 10 comprend également une entrée 18 pour le signal à filtrer, une sortie 20 pour le signal filtré et une entrée de commande 21 pour une tension de commande $V_{ds}$ de la capacité électrique d'un condensateur interne.

L'un des deux modules de filtrage 14A, 14B est connecté à l'entrée 16 pour un signal fréquentiel 22 à filtrer. Le signal fréquentiel 22 à filtrer est avantageusement compris entre 30 MHz et 300 MHz, plus avantageusement le signal fréquentiel à filtrer est compris entre 30 MHz et 50 MHz.

L'autre module de filtrage 14B est connecté à la sortie 20 pour un signal filtré 24.

Les deux modules de filtrage 14A, 14B comportent chacun un ensemble d'impédances de filtrage 26, aussi appelé résonateur de filtrage 26. Les fréquences de résonance de l'ensemble d'impédances de filtrage 26 de chaque module de filtrage 14A, 14B sont préférablement les mêmes afin d'assurer un filtre 10 de bonne qualité.

Le résonateur de filtrage 26 comporte préférablement une structure symétrique. En variante, la structure symétrique inclut deux transistors principaux 28 chacun relié à l'entrée de commande 21sur leur drain respectif.

La tension de commande $V_{ds}$ appliquée dans chaque résonateur de filtrage 26 est préférablement identique. La tension de commande $V_{ds}$ atteint, par exemple, jusqu'à 130V dépendant du modèle de transistor 28.

Le résonateur de filtrage 26 comporte un transistor principal 28. Le transistor principal 28 comprend par construction un condensateur interne (non représenté) disposé entre un point haut et un point bas correspondant au drain et à la source respectivement du transistor principal 28.

Avantageusement, le transistor principal 28 est de type à effet de champ à grille métal-oxyde.

La source et la grille du transistor principal 28 sont connectées à des potentiels électriques principaux pour un fonctionnement du transistor principal 28 dans un état bloqué. Plus particulièrement, la source et la grille du transistor principal 28 sont connectées à une masse 29.

Cela veut dire que la tension entre la source et la grille, notée $V_{gs}$, est nulle.

Ainsi, lorsque le transistor principal 28 est dans un état bloqué, le transistor principal 28 se comporte comme un interrupteur de courant. Ainsi le drain et la source du transistor principal 28 ne sont reliées qu'au travers le condensateur interne.

Lorsque la charge électrique Q du condensateur interne est fixe, une modification de la tension ΔV aux bornes du condensateur interne provoque une modification inversement proportionnelle de la capacité électrique C du condensateur interne. Cela est montré par l'équation suivante :

$$Q = C.\Delta V \qquad\qquad \text{[Eq. 1]}$$

L'ensemble d'impédances de filtrage 26 comporte en outre l'entrée de commande 21 pour la tension de commande $V_{ds}$ de la capacité du transistor principal 28. En d'autres termes, dans la figure 1, la modification de la tension ΔV aux bornes du condensateur interne dans l'équation 1 correspond à la tension de commande $V_{ds}$ appliquée au transistor principal 28. Cela correspond à la tension entre l'entrée de commande 21 et la source du transistor principale.

L'équation 1 reste vraie tant que le transistor reste dans une plage de valeurs où le transistor principale 28 est bloqué, selon l'équation suivante :

$$V_{ds} \geq V_{gs} + V_T \qquad\qquad \text{[Eq.2]}$$

Où $V_T$ correspond à la tension seuil.

Ainsi, la plage de valeurs où le transistor principale 28 est bloqué dépend de la tension de seuil $V_T$. Préférablement, $V_{ds}$ est compris entre 20 V et 120 V. Plus préférablement, $V_{ds}$ est compris entre 30 V et 120 V.

Préférentiellement, le résonateur de filtrage 26 comporte un transistor optionnel 32. Dans le cas de la figure 1, le transistor optionnel 32 est un transistor du même type que le transistor principal 28. Le drain du transistor optionnel 32 est relié à l'entrée de commande 21. La source du transistor optionnel 32 est, quant à elle, connectée à un potentiel électrique 34, et la grille est connecté à la masse 29 pour un fonctionnement du transistor optionnel dans un état bloqué.

En variante, le transistor optionnel 32 est un autre type de transistor tel qu'un transistor de type JFET (de l'anglais *Junction Field Effect Transistor)* ou MESFET (de l'anglais *MEtal Semiconductor Field Effect Transistor).*

La source du transistor optionnel 32 est reliée à une bobine de couplage 38 et une bobine résonante 39.

En variante encore, le résonateur de filtrage 26 comporte plusieurs transistor optionnel 32 alignés en série entre le drain du transistor principal 28 et les bobines de coupage 38 et résonante 39.

En variante encore, le ou les transistors secondaire 32 sont remplacés par une ou plusieurs capacités fixes.

La bobine résonante 39 est par exemple connectée en parallèle entre l'un des potentiels électriques 34 et la masse 29.

La bobine de couplage 38 est connectée entre l'un des potentiels électriques 34 et la branche de connexion 16.

La bobine de couplage 38 permet de coupler les deux modules de filtrage 14a, 14b qui oscillent à la même fréquence.

La bobine résonante 39 forme avec le condensateur interne du transistor principal 28, et optionnellement celui du transistor optionnel 32 , la fréquence de résonance du filtre 10.

La figure 1 utilise une bobine résonante 39 et une bobine de couplage 38 mais leur nombre varie selon les performances requises du filtre 10.

Les deux modules de filtrage 14A, 14B comportent optionnellement un circuit d'adaptation d'impédance 40. Le circuit d'adaptation d'impédance 40 comprend un condensateur d'entrée 42 et une bobine d'entrée 44.

Le condensateur d'entrée 42 est connecté entre l'entrée 18 ou la sortie 20 et l'ensemble d'impédances de filtrage 26.

La bobine d'entrée 44 est avantageusement connectée entre l'entrée 18 et la masse 29.

Les deux modules de filtrage 14A, 14B comportent de préférence une unité de filtrage 46 pour l'entrée de commande 21. L'unité de filtrage 46 comprend un condensateur de filtrage 48 et une bobine de filtrage 50. L'unité de filtrage 46 est disposée entre le drain du transistor principal 28 et l'entrée de commande 21.

Préférentiellement, l'unité de filtrage 46 est disposée entre les drains des transistors 28 et 32 et l'entrée de commande 21.

Le condensateur de filtrage 48 est connecté entre l'entrée de commande 21 et la masse 29.

La bobine de filtrage 50 est connectée entre l'entrée de commande 21 et le drain du transistor principal 28.

Préférentiellement, la bobine de filtrage 50 est connectée entre l'entrée de commande 21 et les drains des transistors 28 et 32.

Le filtre analogique 10 à gabarit variable selon l'invention permet de filtrer le signal entre l'entrée 18 et la sortie 20 en consommant moins d'énergie. Cela est possible grâce à l'utilisation des transistors dans un état bloqué au lieu des diodes à capacités commutées. En effet, l'état bloqué des transistors est relativement avantageux puisqu'il ne consomme pas d'énergie, en négligeant le courant de fuite.

L'unité de filtrage 46 permet, quant à elle, d'améliorer le gabarit du filtre 10 en filtrant sur une bande plus large et avec une pente plus raide de la fonction de transfert du filtre 10 (et non-retour du courant dans la commande).

Ainsi, l'invention permet d'avoir un filtre très robuste et peu énergivore dans la plage des très hautes fréquences, c'est-à-dire entre 30MHz et 300 MHz, et plus préférablement entre 30MHz et 50MHz.

**Revendications**

1. Filtre analogique (10) à gabarit variable comportant, entre une entrée (18) pour un signal fréquentiel (22) à filtrer et une sortie (20) pour un signal filtré (24), un ensemble d'impédances de filtrage (26) avec au moins un condensateur à capacité variable (28, 32) disposé entre un point haut et un point bas, et comportant une entrée de commande (21) pour une tension de commande ( $V_{ds}$ ) de la capacité du condensateur,
   **caractérisé en ce que** le condensateur à capacité variable (28) est un transistor principal (28) dont la source et le drain forment respectivement les points haut et bas, l'entrée de commande (21) étant reliée au drain, la source et la grille étant connectées à des potentiels électriques pour un fonctionnement du transistor principal (28) dans un état bloqué.

2. Filtre selon la revendication 1, dans lequel la source et la grille du transistor principal (28) sont connectées à la masse (29).

3. Filtre selon la revendication 1 ou 2, dans lequel le signal fréquentiel à filtrer (22) est compris entre 30 MHz et 300 MHz.

4. Filtre selon l'une quelconque des revendications précédentes, dans lequel le transistor principal (28) est de type à effet de champ à grille métal-oxyde.

5. Filtre selon l'une quelconque des revendications précédentes, dans lequel l'ensemble d'impédances de filtrage (26) comporte un transistor optionnel (32) dont le drain est relié à l'entrée de commande (21) et dont la source et la grille sont connectées à des potentiels électriques (34, 36) pour un fonctionnement du transistor optionnel (32) dans un état bloqué.

6. Filtre selon l'une quelconque des revendications précédentes, comportant un circuit d'adaptation d'impédance (40), le circuit d'adaptation d'impédance (40) comprenant un condensateur d'entrée (42) et une bobine d'entrée (44), la bobine d'entrée (44) étant connectée entre l'entrée (18) et la masse (29), le condensateur d'entrée (42) étant connecté entre l'entrée (18) et l'ensemble d'impédances de filtrage (26).

7. Filtre selon l'une quelconque des revendications précédentes, comportant une unité de filtrage (46) disposée entre le drain du transistor principal (28) et l'entrée de commande (21), l'unité de filtrage (46) comprenant un condensateur de filtrage (48) et une bobine de filtrage (50), le condensateur de filtrage (48) étant connecté entre l'entrée de commande (21) et la masse (29), la bobine de filtrage (50) étant connectée entre l'entrée de commande (21) et le drain du transistor principal (28).

8. Filtre selon l'une quelconque des revendications précédentes, dans lequel, l'ensemble d'impédances de filtrage (26) comporte une structure symétrique avec deux transistors principaux (28), chacun reliés à l'entrée de commande (21).

9. Filtre selon la revendication 8, dans lequel la tension de commande appliquée à chaque transistor principal (28) est identique.

FIG.1

Europäisches
Patentamt

European
Patent Office

Office européen
des brevets

**RAPPORT DE RECHERCHE EUROPEENNE**

Numéro de la demande

**EP 25 22 4119**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 8 928 431 B2 (KOECHLIN MICHAEL [US]; HITTITE MICROWAVE CORP [US]) 6 janvier 2015 (2015-01-06) * colonne 3, ligne 21 - colonne 4, ligne 3; figure 2 * | 1-9 | INV. H03H11/04 |
| X | US 7 548 136 B1 (SHAH PETER JIVAN [US]) 16 juin 2009 (2009-06-16) * colonne 1, ligne 22 - ligne 49; figure 9 * | 1-4,8,9 | |

-----

-----

DOMAINES TECHNIQUES
RECHERCHES (IPC)

H03H

Le présent rapport a été établi pour toutes les revendications

| Lieu de la recherche | Date d'achèvement de la recherche | Examinateur |
|---|---|---|
| Munich | 14 avril 2026 | Mesplede, Delphine |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

...............................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 22 4119

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-04-2026

| Document brevet cité au rapport de recherche | | Date de publication | Membre(s) de la famille de brevet(s) | | Date de publication |
|---|---|---|---|---|---|
| US 8928431 | B2 | 06-01-2015 | CN | 102148610 A | 10-08-2011 |
| | | | EP | 2355340 A1 | 10-08-2011 |
| | | | US | 2011187449 A1 | 04-08-2011 |
| US 7548136 | B1 | 16-06-2009 | AUCUN | | |